# EUROPEAN PATENT APPLICATION

(11) **EP 4 790 747 A1**
(43) Date of publication of application: **12.08.2026**
(21) Application number: 25157019.8
(22) Date of filing: 11.02.2025
(51) Int. Cl.: H01L 21/67, G01D 5/26, G01N 21/95, H01L 21/66

(54) **BONDING TOOL**

(71) Applicant: ASML Netherlands B.V., 5500 AH Veldhoven (NL)
(72) Inventor: ALMASI, Attaallah, 5500 AH Veldhoven (NL)
(74) Representative: ASML Netherlands B.V.

(57) **Abstract**

A bonding tool is configured to bond a first substrate to a second substrate. The bonding tool comprises a measurement system. The measurement system is configured to measure a distance to a surface of at least one of the first substrate and the second substrate. The measurement system comprises at least one optical fiber and a radiation source. The at least one optical fiber has a distal end distanced from the surface so as to form an optical cavity of a Fabry-Pérot interferometer between the respective distal ends and the surface. The radiation source is configured to provide interrogation radiation of different wavelengths to the at least one optical fibers.

## Description

### TECHNICAL FIELD

The present disclosure relates generally to a bonding tool, a topography measurement system and a method for measuring a distance to a surface.

### BACKGROUND

In manufacturing processes of integrated circuits (ICs), multiple substrates (which may be finished or unfinished ICs, e.g., whole wafers, diced wafers, partially diced wafers, chips, die, etc.) may be placed in contact, stacked, bonded, or otherwise joined (e.g., to heterogeneous or homogeneous devices) at various points in the fabrication process. Heterogeneous integration, e.g., the integration of different circuits or other patterned devices, may rely upon joining of specific portions (for example, conductive contact elements) of multiple substrates. These specific portions may be aligned in three-dimensional space to ensure functional connectivity.

Alignment of the substrates, which may each have multiple fabrication layers, different critical dimensions, different nodes, packaging, etc., may require different techniques than those used for lithography during fabrication. As the physical sizes of IC components continue to shrink, and their structures continue to become more complex, accuracy in integration is becoming more important.

In the context of semiconductor manufacture, improvements in substrate placement and alignment during joining operations (e.g., improvements in heterogeneous integration) lead to improvements in the overall IC manufacturing process. For example, throughput of the manufacturing process may be improved (e.g. because of a reduction in the number of defective devices formed).

### SUMMARY

According to an embodiment, the present disclosure provides a bonding tool configured to bond a first substrate to a second substrate, the bonding tool comprising:
a measurement system configured to measure a distance to a surface of at least one of the first substrate, the second substrate, a substrate holder configured to hold the first substrate and a substrate holder configured to hold the second substrate, the measurement system comprising:
at least one optical fiber having a distal end distanced from the surface so as to form an optical cavity of a Fabry-Pérot interferometer between the distal end and the surface; and
a radiation source configured to provide interrogation radiation of different wavelengths to the at least one optical fiber.

According to an embodiment, the present disclosure provides a topography measurement system configured to measure a topography of a surface of a substrate, the topography measurement system comprising:
a plurality of optical fibers having respective distal ends distanced from the surface so as to form respective optical cavities of respective Fabry-Pérot interferometers between the respective distal ends and the surface; and
a radiation source configured to provide interrogation radiation of different wavelengths to the plurality of optical fibers such that a first group of the optical fibers receives interrogation radiation of a first wavelength and a second group of the optical fibers receives interrogation radiation of a second wavelength.

According to an embodiment, the present disclosure provides a method for measuring a distance to a surface of at least one of a first substrate, a second substrate, a first substrate holder configured to hold the first substrate and a second substrate holder configured to hold the second substrate, wherein the first substrate and the second substrate are to be bonded in a bonding tool, the method comprising:
arranging at least one optical fiber to have a distal end distanced from the surface so as to form an optical cavity of a Fabry-Pérot interferometer between the distal end and the surface; and
providing interrogation radiation of different wavelengths to the at least one optical fiber.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts. The accompanying schematic drawings include the following.
Figures 1A-1D are schematic diagrams illustrating an exemplary die bonding method.
Figure 2 is a schematic diagram illustrating a bonding tool.
Figure 3 schematically depict a measurement system of a bonding tool, for example shown in Figure 2.
Figure 4 schematically depicts the measurement system shown in Figure 3.
Figure 5 schematically depicts part of the measurement system shown in Figure 4.
Figure 6 schematically depicts another view of the measurement system shown in Figure 4.
Figure 7 schematically depicts an alternative measurement system.
Figure 8 schematically depicts an alternative measurement system.
Figure 9 schematically depicts part of a measurement system near an alignment system.
Figure 10 schematically depicts a lithographic apparatus.

### DETAILED DESCRIPTION

Embodiments of the present disclosure are described in detail with reference to the drawings, which are provided as illustrative examples of the disclosure so as to enable those skilled in the art to practice the disclosure. Notably, the Figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure.

Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc.

The skilled artisan will appreciate that, in the context of such alternative applications, any use of the terms "wafer" or "die" in this text should be each considered as interchangeable with the more general term "substrate". The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer" - that is a "die" may be produced by dicing or otherwise dividing a "wafer". The term "die" should be considered as interchangeable with the term chip, chiplet, or other terms for IC divisions.

A patterning apparatus (for example, a lithographic apparatus) can comprise, or can form, one or more patterns, which may correspond to one or more die. The patterns can be generated utilizing CAD (computer-aided design) programs, based on a pattern or design layout, this process often being referred to as EDA (electronic design automation).

As used throughout this application "or", unless indicated otherwise, takes a non-exclusive meaning, e.g., encompassing both "and" and "or".

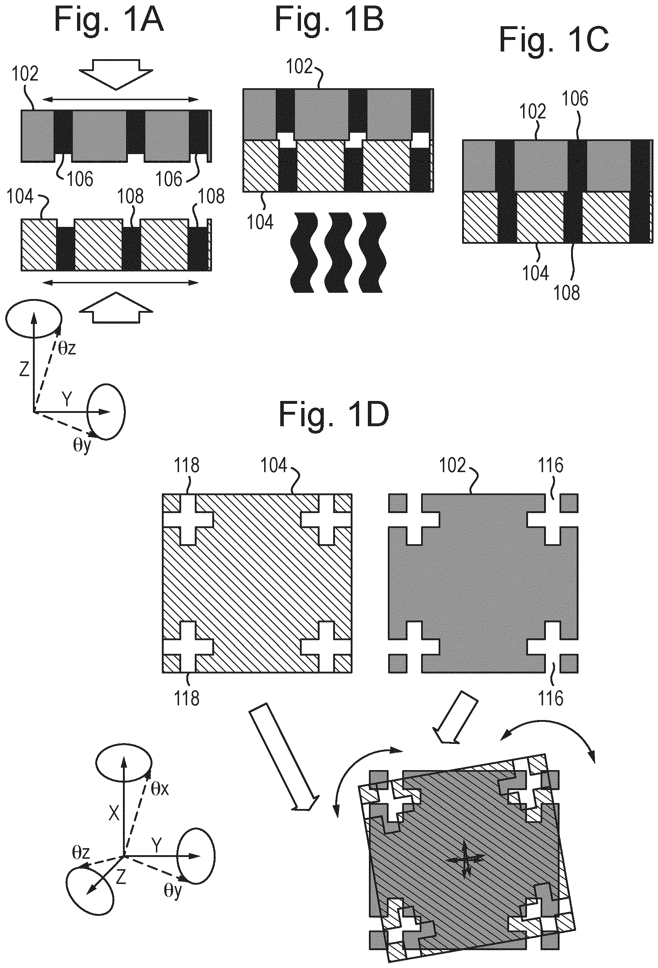

Reference is now made to Figures 1A-1D, which are schematic diagrams illustrating an exemplary die bonding method consistent with embodiments of the present disclosure. The die bonding method comprises bonding one die to another die. As will be appreciated, the bonding technique may be applied to bond any substrate (e.g. a whole wafer, a diced wafer, a partially-diced wafer, a chip, a die, etc.) to any other substrate (e.g. a whole wafer, a diced wafer, a partially-diced wafer, a chip, a die, etc.). For example, the bonding technique may be used to bond a die to another die, where the other die is a part of a wafer.

As shown in Figures 1A-1D, the exemplary die bonding method may involve a donor die 102 and a target die 104. Herein, the term "donor" and the term "target" are used for ease of description. It should be understood that the term "donor" and the term "target" are provided for reference and are relative and that elements described as corresponding to a "donor" can instead correspond to a "target" and vice versa.

The exemplary die bonding method is depicted in relation to a reference set of axes. The reference axes are provided for ease of description only and are not to be taken as limiting. Included methods and apparatuses can instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The standard set of axes is chosen such that the fabrication plane of the die (i.e., a wafer surface) lies in the x-y plane and where the fabrication direction is parallel or antiparallel to the z-axis for both the donor die and target die.

The donor die 102 may have electrically active areas 106. The electrically active areas 106 may correspond to vias (e.g., through silicon vias (TSVs)), electrical contact lines, contact pads, packaging pads, or other electrically conductive areas. The donor die 102 may have one or more electrically inert areas (for example, electrically insulating areas or dielectric areas) outside of the electrically active areas 106. The electrically active areas 106 may be recessed (as shown) with respect to other surfaces of the donor die 102. The electrically active areas 106 may correspond to contacts (e.g., to source, to drain, to gate, etc.) to electrical devices within the donor die 102 (not shown). The target die 104, likewise, may have electrically active areas 108, which may have similar properties to the electrically active areas 106.

Figures 1A-1C depict a cross-sectional view of portions of the exemplary die bonding method. As shown in Figure 1A, the exemplary die bonding method may involve alignment of at least some of the electrically active areas 106 of the donor die 102 with at least some of the electrically active areas 108 of the target die 104. The exemplary die bonding method may involve bringing the donor die 102 into contact with the target die 104 while maintaining alignment between the electrically active areas 106 in the electrically active areas 108. As further shown in Figure 1A, the donor die 102 and the target die 104 may be brought together along the z-axis, while the position of the donor die 102 and/or the target die 104 may be adjusted in the x-y plane (e.g., perpendicular to the z-axis of approach). The alignment may be complicated by the multiple layers of the donor die 102 or the multiple layers of the target die 104, which may be optically opaque.

Upon bringing the donor die 102 into contact with the target die 104, an initial bond may be formed between the donor die 102 and the target die 104. The initial bond may be between dielectric areas of the donor die 102 and dielectric areas of the target die 104. The initial bond may comprise intermolecular forces, such as Van der Waal's forces and the like.

As shown in Figure 1B, the donor die 102 and the target die 104 may be annealed after contact. Annealing may be or include heat annealing, electrical annealing, electrostatic processes, etc. As shown in Figure 1C, annealing may cause physical or chemical changes in the electrically active areas 106 of the donor die 102 or in the electrically active areas 108 of the target die 104 which may cause physical contact or electrical contact between the electrically active areas 106 and the electrically active areas 108. Annealing may therefore produce electrical connectivity between elements of the donor die 102 and the target die 104 (e.g., integration). This electrical connectivity may occur even if the electrically active areas 106 and the electrically active areas 108 differ - for example, have different recessed depths, are made up of different materials, have different dimensions, etc.

Figure 1D depicts a plan view of an example die bonding method according to this disclosure. As shown in Figure 1D, the donor die 102 and the target die 104 may have alignment marks along the x-y plane to facilitate alignment of the die as a whole. Alignment marks in the x-y plane of die (e.g., alignment marks 116 on the donor die 102 or alignment marks 118 on the target die 104) may reduce the area available for circuitry. Alignment marks may be additively or subtractively fabricated, such as by etching or deposition in the z-direction. In direct die-to-die alignment, the donor die 102 and the target die 104 are aligned directly with one another.

Alignment marks (such as alignment marks used for alignment of one or more fabrication layer during lithography) used during fabrication of wafers may be placed in waste areas, such as areas between chips, which may then be destroyed (e.g., removed) during dicing. Dicing herein refers to mechanical separation of areas of a wafer (e.g., a unit of manufacture) into smaller areas (e.g., dies or chips) which may contain one or more units of operation (e.g., a logic device, a memory unit, etc.). Dicing may operate using any appropriate method - for example, scribing and breaking, mechanical sawing, laser cutting, etc. - and may destroy (e.g., grind to powder or otherwise render inoperable for circuitry placement) a non-zero linewidth portion of the wafer volume when separating die.

The electrically active areas 106 of the donor die 102 or the electrically active areas 108 of the target die 104 (not shown in Figure 1D) or other surface features may function as reference marks for alignment (e.g., alignment marks) of the donor die 102 and the target die 104.

The donor die 102 and the target die 104 may be aligned in three dimensions before or during contact between the donor die 102 and the target die 104. For example, the donor die 102 or the target die 104 may be positioned or adjusted in the x-y plane as the donor die 102 in the target die 104 are contacted. The donor die 102 or the target die 104 may be positioned or adjusted by operation of a die actuator or other die-scale elements, such as by piezoelectric stepper elements, or by operation of a wafer chuck or other wafer-scale elements, such as by stepper elements.

The position of the donor die 102 or the target die 104 may be adjusted with respect to up to six degrees of freedom. For example, given an origin point at the center of the donor die 102, the donor die 102 may be adjusted by movement along the x-axis (e.g., in a positive or negative X direction), along the y-axis (e.g. in a positive or negative Y direction), along the z-axis (e.g., in a positive or negative Z direction). The donor die 102 may also be adjusted rotationally with respect to each of those axes - e.g., rotated with respect to the x-axis, rotated with respect to the y-axis, rotated with respect to the z-axis. That is, the donor die 102 may be adjusted by free rotation in space accounted for by six different types of movement (where the movements listed above are provided as examples but where the movements may be described by other axes).

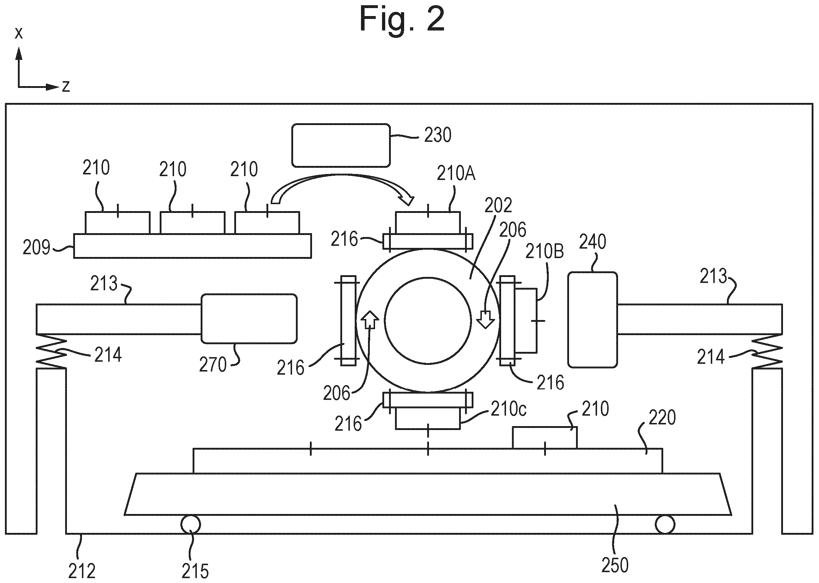

Figure 2 is a schematic diagram illustrating a bonding tool for the placement of donor substrates 210 onto an acceptor substrate 220 by a moveable stage 202. Figure 2 is described with reference to "donor" substrates 210 (e.g. donor substrates 210A-210C) and "acceptor" substrates 220, which are relative descriptors - a donor substrate may instead be an acceptor substrate, and vice-versa. The bonding tool depicted in Figure 2 may be configured to place any donor substrate (e.g. a whole wafer, a diced wafer, a partially-diced wafer, a chip, a die, etc.) onto any target substrate (e.g. a whole wafer, a diced wafer, a partially-diced wafer, a chip, a die, etc.). For example (and as depicted in Figure 2), the bonding tool may be configured to place a donor die 210 onto an acceptor wafer 220.

The acceptor substrate 220 may comprise one or more target portions. For example, the acceptor substrate 220 may comprise one or more target dies formed therein (prior to being diced/separated). The method/apparatus depicted in Figure 2 may be to place a donor die 210 onto a target die of the acceptor wafer 220. In the case that the acceptor wafer 220 comprises a plurality of target dies, the method may be repeated such that each donor die 210 is placed onto one of the plurality of target dies on the acceptor wafer 220.

The placing of a donor substrate 210 onto an acceptor substrate 220 may be a part of a bonding process comprising bonding the donor substrate 210 and the acceptor substrate 220 together. The bonding between the donor substrate 210 and the acceptor substrate 220 may be the same, or similar to, the bonding described with reference to Figure 1.

The stage 202 may be substantially circular in the x-z plane, with a longitudinal axis along the y-direction (e.g. the stage 202 may be substantially cylindrical in three dimensions). The stage 202 may instead have a different cross-sectional shape, such as square, hexagonal, etc. The stage 202 may have a symmetrical (e.g., as shown) cross-section with one or more axis of symmetry, or asymmetrical cross-sectional area (for example, an irregular polygon).

The stage 202 may comprise receiver portions 216. The receiver portions 216 each may be, or may comprise, a recess. The receiver portions 216 may each be configured to receive and/or accept and/or support and/or hold and/or clamp a donor substrate 210. The receiver portions 216 may each be configured to clamp a donor substrate 210 thereto using a vacuum clamping means and/or an electrostatic clamping means.

The placement of the receiver portions 216 may be symmetrical or asymmetrical around the cross-sectional area of the stage 202. The stage 202 may have a substantially symmetrical cross-section but have asymmetric placement of receiver portions 216. For example, the stage 202 may have a cross-section that is a regular hexagon but have receiver portions 216 placed asymmetrically along longitudinal faces.

The stage 202 may be a moveable stage, e.g. a rotatable stage. The stage 202 may be controllably moved (e.g. rotated) in a direction 206 about the longitudinal axis. The direction 206 is provided as an example. The stage 202 may instead be rotated in an opposite direction or any appropriate direction, translated along the x, y, or z direction or any combination thereof. The stage 202 may be operated in both rotational and translational modes, including sequentially or at the same time. For example, the stage 202 may move in the negative x-direction towards a support structure 250 while also rotating about the longitudinal axis. The stage 202 may move continuously or intermittently. For example, the stage 202 may rotate in the direction 206 and stop at four (or fewer or more) positions corresponding to operations in the placement of the donor substrate 210.

Example positions and operations will now be further discussed. These positions and operations are provided as examples only, and multiple operations may be performed at a single position, a position may not correspond to an operation (e.g., may correspond to a null operation), an operation may be performed at multiple positions (e.g., the operation may be performed multiple times or in steps divided between positions), etc. These positions and operations are described as happening in discrete positions (such as when movement of the stage 202 is substantially zero), but the positions may instead correspond to continuous (or quasi-continuous movement) or operations may occur while the stage 202 is moving in one or more directions (e.g., rotationally, translationally, etc.).

A first position, such as corresponding to the position depicted for the donor substrate 210A, may correspond to placement of a donor substrate 210A in a receiver portion 216 of the stage 202. The donor substrate 210A may be placed on the receiver portion 216 by a pick and place element 230. The pick and place element 230 may place the donor substrate 210A on the stage 202 on the receiver portion 216 based on alignment information, based on positional information of the stage 202, etc. The pick and place element 230 may place the donor substrate 210A on the support structure at a given position relative to the receiver portion 216. For example, the pick and place element 230 may center the donor substrate 210A relative to the receiver portion 216.

The second position, such as corresponding to the position depicted for the donor substrate 210B, may correspond to measurement of the position of the donor substrate 210B relative to the receiver portion 216 of the stage 202. The position (e.g., location) of the donor substrate 210B may be measured by a location measurement element 240. The location measurement element 240 may measure an actual position of the donor substrate 210B, in relative (such as relative to the receiver portion 216) or absolute terms (such as in distances from an origin point on the stage 202, on the location measurement element 240, etc.).

The location measurement element 240 may be a camera, e.g., a two-dimensional camera, two or more one-dimensional cameras, an optical camera, etc., or another measurement device. The location measurement element 240 may be made up of multiple location measurement elements, such as an in-plane measurement device which may measure locations in the y-z plane (relative to the reference axes) and an out-of-plane measurement device which may measure locations or distances in the x direction (relative to the reference axes). The location measurement element 240 may include one or more confocal microscopes, which may measure depth (or other distance). The location measurement element 240 may measure position, relative or absolute position, using overlay diffraction or other diffraction-based methods. The location measurement element 240 may operate in a scanning mode or from a fixed position relative to the stage 202.

Once the position of the donor substrate 210B is measured, the stage 202 may move (e.g., rotate in the direction 206), so that the donor substrate 210B occupies the position of the donor substrate 210C, which may be a third position of the stage 202. The third position of the support structure will now be described with reference to the donor substrate 210C.

The third position, such as corresponding to the position depicted for the donor substrate 210C, may correspond to placement of the donor substrate 210C on the acceptor substrate 220. The acceptor substrate 220 may comprise a target portion (e.g. a target die, as described above). The bonding tool may be configured to place the donor substrate 210C at the target portion of the acceptor substrate 220 by bringing the donor substrate 210C into contact with the target portion of the acceptor substrate 220. As the donor substrate 210C is brought into contact with the target portion of the acceptor substrate 220, initial bonding forces (e.g. Van der Waal's forces and the like) may be formed between the donor substrate 210C and the acceptor substrate 220.

The acceptor substrate 220 may be supported by the support structure 250. The donor substrate 210C may be brought into contact with the acceptor portion by motion of the stage 202 towards the support structure 250, motion of the support structure 250 towards the stage 202, or a combination thereof. Motion of the stage 202 towards the support structure 250 may comprise movement in the z-direction. Motion of the support structure 250 towards the stage may comprise movement in the z-direction.

Once the donor substrate 210C is placed on the acceptor substrate 220, the stage 202 and the support structure 250 may operate (individually or in concert) to place at least one additional donor substrates on the acceptor substrate 220. For example, the stage 202 and the support structure 250 may move relative to one another in the x- or y-direction so that another part of the acceptor substrate 220 is proximate to the stage 202 (e.g. so that another target portion of the acceptor substrate 220 is aligned with the stage 202). The relative motion of the stage 202 and the support structure 250 may be caused by movement of the support structure 250 (e.g. by the positioning system for the support structure 250).

After placing the donor substrate 210C onto the acceptor substrate 220, the stage 202 may rotate to align the next donor substrate on the stage (i.e. the donor substrate 210B) with the acceptor substrate 210. Generally, the stage 202 may be rotatable to align different donor substrate 210 (and/or different receiver portions 216 of the plurality of receiver portions 216) with the acceptor substrate 220.

A direction of gravity is not depicted, but the placement of the donor substrate 210C on the acceptor substrate 220 may experience gravitation effects. For example, the placement of the donor substrate 210C on the acceptor substrate 220 may be encouraged by gravity (e.g., occur in the direction of gravity) or be retarded by gravity (e.g., occur opposite the direction of gravity). Gravitational effects may be balanced by clamps, suction, vacuum, and other forces.

The stage 202 may comprise an actuator (not shown). The actuator may be configured to cause the stage 202 to accept the donor substrates 210 from the pick & place element 230 and subsequently transport the donor substrates 210 to location measurement element 240 and finally place the donor substrates 210 on the acceptor substrate 220. The actuator may be configured to rotate the stage 202 in the manner described above.

The support structure 250 may be configured to move the acceptor substrate 220 with high accuracy. The bonding tool may comprise a base frame 212. As shown in Figure 2, the support structure 250 that supports the acceptor substrate 220 may be coupled to the base frame 212 by at least one bearing 215. The support structure 250 may comprise a plurality of stages that may be stacked relative to each other via a plurality of bearings.

For example, the support structure 250 may comprise a long stroke module for relatively coarse positioning of the acceptor substrate 220 over a longer distance, and a short stroke module for higher accuracy positioning of the acceptor substrate 220 over a shorter distance. The short stroke module may be stacked on the long stroke module. The short stroke module and the long stroke module may each be part of a positioning system configured to position the support structure 250 (and therefore to position the acceptor substrate 220 supported on the support structure 250) in the horizontal plane, i.e. in the x- and y-directions. The short stroke module and the long stroke module may each comprise one or more actuators configured to move the support structure 250 relative to the base frame 212. Thus, in general, the positioning system may comprise one or more actuators configured to move the support structure 250.

The positioning system may comprise one or more sensors configured to determine the position of the support structure. The one or more sensors may be interferometric sensors, as described in US6020964, the entirety of which is hereby incorporated by reference.

As shown in Figure 2, the bonding tool may comprise a metrology frame 213.

The metrology frame 213 may be referred to as an isolated frame. The metrology frame 213 may be isolated relative to the base frame 212. The bonding tool may comprise an isolator 214. The isolator 214 may be configured to substantially isolate the metrology frame 213 from the base frame 212. By isolating the metrology frame 213 from the base frame 212, vibrations of the base frame 212 may have less of an effect on the metrology frame 213.

As shown in Figure 2, in an embodiment the bonding tool comprises an acceptor exchange element 270. The acceptor exchange element 270 may be secured to the metrology frame 213. The acceptor exchange element 270 is configured to exchange a receiver portion 216 of the stage 202 for a replacement receiver portion. Alternatively, the acceptor exchange element 270 may be omitted.

A controller may be configured to control the stage 202 and the support structure 250 so as to accurately place a donor substrate 210 onto a target portion of the acceptor substrate 220. Alignment between the donor substrate 210 and the acceptor substrate 220 in the horizontal (x and y) directions is important. This is because, as described above, the donor substrate 210 and the acceptor substrate 220 each have electrically-active areas which must come into contact with each other for the combination of the donor substrate 210 and the acceptor substrate 220 to function as intended. As above, a direct substrate-to-substrate alignment method may be performed. Additionally or alternatively, an alignment method may be performed whereby the position of the donor substrate 210 is determined relative to a reference, and the position of the acceptor substrate 220 is determined relative to a reference, and the substrates 210, 220 are aligned using the two determined positions. Such an alignment method is described below.

To accurately align the donor substrate 210 and the acceptor substrate 220, the position of the donor substrate 210 relative to the acceptor substrate 220 may be determined. The determination of the position of the donor substrate 210 relative to the acceptor substrate 220 may be direct, indirect, explicit or implicit. For example, the actual position of the donor substrate 210 relative to the acceptor substrate 220 itself may not be explicitly determined, but another parameter which is indicative of the position of the donor substrate 210 relative to the acceptor substrate 220 may be determined (and thus the position of the donor substrate 210 relative to the acceptor substrate 220 is determined indirectly/implicitly). The determination of the position of the donor substrate 210 relative to the acceptor substrate 220 may be may be done with use of alignment marks (e.g. like the alignment marks 118, 116 depicted in Figure 1) on the donor substrate 210 and the acceptor substrate 220.

Additionally or alternatively, the position of the donor substrate 210 relative to the acceptor substrate 220 may be determined based on determining the position of the stage 202 (e.g. the position of the receiver portion 216 in the third position) relative to the support structure 250. This may be possible because the position of the acceptor substrate 220 relative to the support structure 250 is accurately known and/or the position of the donor substrate 210 relative to the stage 202 (e.g. relative to the receiver portion 216) is accurately known. The position of the receiver portion 216 in the third portion relative to the stage 202 in general may be known and fixed (e.g. because the receiver portion 216 is fixedly coupled to a main body of the stage 202). Thus, knowledge of the position of the stage 202 relative to the support structure 250 may be equivalent to knowledge of the position of the receiver portion 216 in the third position relative to the support structure, and vice-versa.

The position of the acceptor substrate 220 relative to the support structure 250 may be known through a metrology process performed by a sensor, e.g. an alignment sensor. The position of the donor substrate 210 relative to the stage 202 (e.g. relative to the receiver portion 216) may be accurately known through measurements performed by the location measurement element 240, as described above.

The alignment sensor used to obtain the position of the acceptor substrate 220 relative to the support structure 250 may be known may be an interferometric sensor. The alignment sensor may be configured to determine a position of an alignment mark (e.g. a diffraction grating) on the acceptor substrate 220 relative to a reference mark (e.g. a diffraction grating) on the support structure 250. An example of an alignment sensor is described in EP 1 372 040B1, the entirety of which is hereby incorporated by reference.

The alignment sensor may be disposed in a measurement station of the bonding tool (not shown). The measurement station may be separate and/or distinct from the bonding station of the bonding tool (i.e. the station depicted in Figure 2).

The bonding tool may comprise two support structures 250, each configured to support an acceptor substrate 220. The support structures 250 may be independently moveable. The support structures 250 may each be provided with a positioning system, such as the positioning system described above. Alternatively, the bonding tool may comprise a single positioning system which is configured to move the two support structures 250 independently. The bonding tool may be configured such that one support structure 250 can be positioned in the measurement station and the other support structure 250 can be positioned in the bonding station, simultaneously. Thus, preparatory measurement processes may be performed on one acceptor substrate 220 (in the measurement station) while bonding processes are performed on another acceptor substrate 220 (in the bonding station).

The position of the stage 202 (e.g. the position of the receiver portion 216 in the third position) relative to the support structure 250 may be determined by measuring the position of the stage 202 using one measurement system, and measuring the position of the support structure 250 using another, independent measurement system (e.g. the positioning system described above). The positions of the stage 202 and the support structure 250 may be measured in different coordinate systems, and/or with respect to different references.

For the bonding tool to be able to accurately place a donor substrate 210 at a target portion of the acceptor substrate 220, the relative position of the support structure 250 and the stage 220 may need to be accurately determined based on the measured position of the stage 202 and/or the measured position of the support structure 250 (specifically, in the x- and y-directions). In some embodiments, the position of the stage 202 in the x- and y-directions may be fixed, such that the determination of the position of the stage 202 relative to the support structure 250 in the x- and y-directions is based on the measurement of the position of the support structure 250 by the positioning system. Even where the position of the stage 202 in the x- and y-directions is fixed, the stage 202 may be able to rotate to align different receiver portions 216 with the acceptor substrate 220.

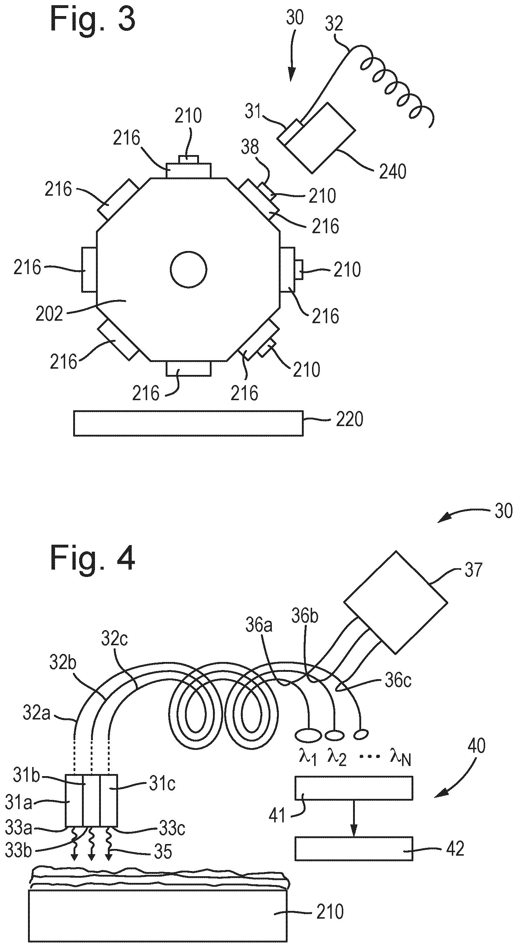

Figure 3 schematically depicts part of a bonding tool, for example of the type shown in Figure 2. Figure 3 shows the stage 202. In the arrangement shown in Figure 3, the stage 202 comprises eight receiver portions 216. Each receiver portion 216 is configured to receive a donor substrate 210. The stage 202 may rotate in the clockwise direction in the orientation shown in Figure 3. The donor substrates 210 may be placed onto the acceptor substrate 220 for bonding. The donor substrates 210 may be die, for example.

Figure 3 schematically depicts the location measurement element 240. The location measurement element 240 may be configured to measure the surface 38 of a donor substrate 210. For example, in the arrangement shown in Figure 3, the location measurement element 240 is configured to measure the surface 38 of the donor substrate 210 in the upper-right diagonal of the stage 202. The surface 38 of the donor substrate 210 faces outwards away from the stage 202. The surface 38 faces towards the location measurement element 240.

In an embodiment the location measurement element 240 is configured to measure the surface 38 for alignment of the donor substrate 210. In an embodiment a controller of the bonding tool is configured to control alignment of the donor substrate 210 based on a measurement made the location measurement element 240.

In an alternative embodiment, bonding tool comprises an alignment system (i.e. alignment sensor) configured to measure alignment of the donor substrate 210. The alignment system may be provided separately from the location measurement element 240. In an embodiment, the bonding tool comprises the location measurement element 240 as described above in addition to alignment system. In an embodiment the alignment system is configured to focus on an alignment marker of the surface 38 of the donor substrate 210.

As shown in Figure 3, in an embodiment the bonding tool comprises a measurement system 30. The topography measurement system 30 is configured to measure a distance to a surface of at least one of a first substrate, a second substrate (where the first substrate and the second substrate are to be bonded to each other), a first substrate holder configured to hold the first substrate and a second substrate holder configured to hold the second substrate. For example, in the arrangement shown in Figure 3, the donor substrate 210 is configured to be bonded to the acceptor substrate 220. The donor substrate 210 may be referred to as a first substrate. The acceptor substrate 220 may be referred to as a second substrate. In an embodiment the measurement system 30 is configured to measure a distance to a surface 38 of at least one of the donor substrate 210 and the acceptor substrate 220. For example, as shown in Figure 3 in an embodiment the measurement system 30 is configured to measure a distance to a surface 38 of the donor substrate 210.

In an alternative embodiment, the measurement system 30 is configured to measure a distance to a surface of the acceptor substrate 220. In a further alternative embodiment, the bonding tool may comprise a plurality of measurement systems 30. For example, a first measurement system 30 may be configured to measure a distance to a surface 38 of the donor substrate 210. A second measurement system 30 may be configured to measure a distance to a surface of the acceptor substrate 220.

In an alternative embodiment, the measurement system 30 is configured to measure a distance to a substrate holder configured to hold the donor substrate 210 or the acceptor substrate 220. For example, the measurement system 30 may be configured to measure a distance to a surface of a receiver portion 216. As another example, the measurement system 30 may be configured to measure a distance to a surface of the support structure 250.

In an embodiment the measurement system 30 is a level sensor, a sensor to measure a distance to a top surface and/or a topography measurement system. For example, in an embodiment the measurement system 30 is configured to measure the distance to the surface 38 at a plurality of different locations on the surface 38. In an embodiment the measurement system 30 is configured to combine a plurality of measurements (e.g. corresponding to different locations of the surface 38) so as to measure a topography of the surface 38. However, it is not essential for the measurement system 30 to measure a topography of the surface 38. It is not essential for the measurement system 30 to measure the distance to the surface 38 at a plurality of different locations on the surface 38. In an embodiment the measurement system 30 is configured to measure the distance to the surface 38 at only one point. The measurement system 30 may be configured to measure the height of the surface 38 by comparing the measured distance to a reference value.

In an embodiment the measurement system 30 is secured to a frame of the bonding tool. For example, the measurement system 30 may be fixed relative to the base frame 212 of the bonding tool. Alternatively, the measurement system 30 may be fixed to the metrology frame 213 of the bonding tool.

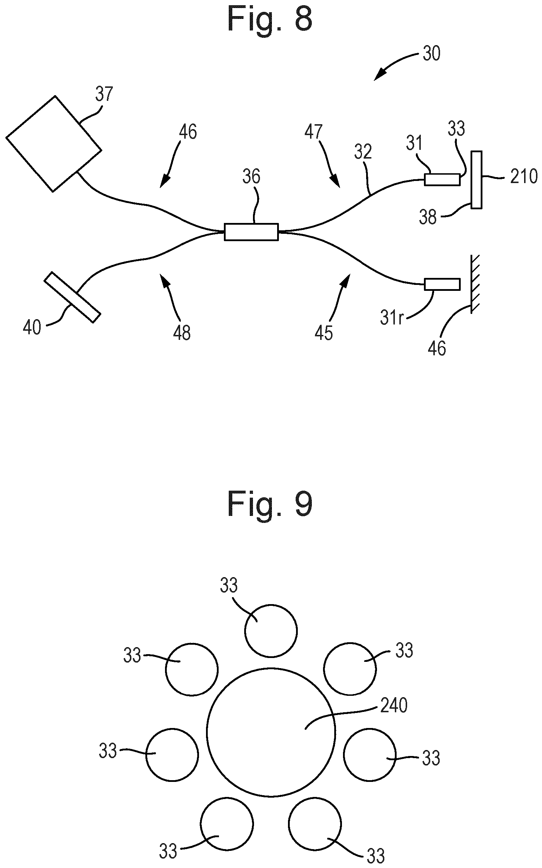

As shown in Figure 3, in an embodiment the measurement system 30 is located near the alignment system, for example near the location measurement system 240. In an embodiment the measurement system 30 has a fixed position relative to the alignment system (which may be referred to as an alignment sensor). As shown in Figure 3, in an embodiment the measurement system 30 is located adjacent to the alignment system. In an embodiment, as described in more detail with reference to Figure 9, the measurement system 30 may be located around an objective of the alignment system.

An embodiment of the invention is expected to improve alignment. By providing the measurement system 30, the height or profile of the surface 38 of the donor substrate 210 may be determined more accurately. In an embodiment, the alignment system is configured to have its focus adjustable dependent on the output of the measurement 30. Knowing the height or profile of the die surface helps to have the alignment system in focus. The alignment may be measured more accurately. The alignment of the donor substrate 210, for example, may be controlled more accurately.

An embodiment of the invention is expected to allow greater control over the bonding of the first substrate (e.g. the donor substrate 210) to the second substrate (e.g. the acceptor substrate 220). In an embodiment a controller of the bonding tool is configured to control the bonding of the bonding dependent on the distance to the surface 38 measured by the measurement system 30. Knowing the height or profile of the die surface for the die to wafer bonding machine helps in having controlled bonding. For example, by determining the height map, the roughness of the surfaces being bonded can be taken into account when controlling propagation of the bond front.

As shown in Figure 3, in an embodiment the measurement system 30 comprises at least one optical fiber 31. Figure 4 schematically shows an embodiment of the topography system 30 in more detail. As shown in Figure 4, in an embodiment the topography system 30 comprises a plurality of optical fibers 31. Merely as an example, the Figure 4 schematically depicts three optical fibers 31a, 31b, 31c. The number of optical fibers 31 may be two, three, four, five or more than five. In an embodiment the number optical fibers 31 is selected depending on what the measurement system 30 is intended to be used for.

An embodiment of the invention is expected to reduce the volume of the bonding tool for a given accuracy of alignment. The optical fiber-based measurement system 30 takes up less volume than a level sensor that uses optical triangulation, for example. Meanwhile the optical fiber-based measurement system 30 may provide sufficiently accurate measurements for improving the bonding, for example by improving alignment during bonding. An embodiment of the invention is expected to achieve an increased resolution. The optical fiber-based measurement system 30 may be configured to direct the interrogation radiation 51 substantially perpendicularly (or close to perpendicularly) to the surface 38. It is not necessary to apply the radiation from the side. This is in contrast to known level sensors that use optical triangulation. The size of a spot of interrogation radiation 51 on the surface 38 may be reduced. The resolution may be increased.

As shown in Figure 4, in an embodiment the plurality of optical fibers 31a, 31b, 31c have respective distal ends 33a, 33b, 33c. In an embodiment the distal ends 33 are distanced from the surface 38 (i.e. the surface to be measured). In an embodiment the distal ends 33 are distanced from the surface 38 so as to form respective optical cavities of respective Fabry-Pérot interferometers between the respective distal ends 33 and the surface 38. As shown in Figure 4, in an embodiment the optical fibers 31 are arranged in a bundle. The measurement system 30 may comprise a multiple fiber bundle. By providing the optical fibers 31 in a bundle, the measurement system 30 may be relatively compact, particularly in the region closer to the surface 38 to be measured. An embodiment of the invention is expected to achieve a compact measurement system 30.

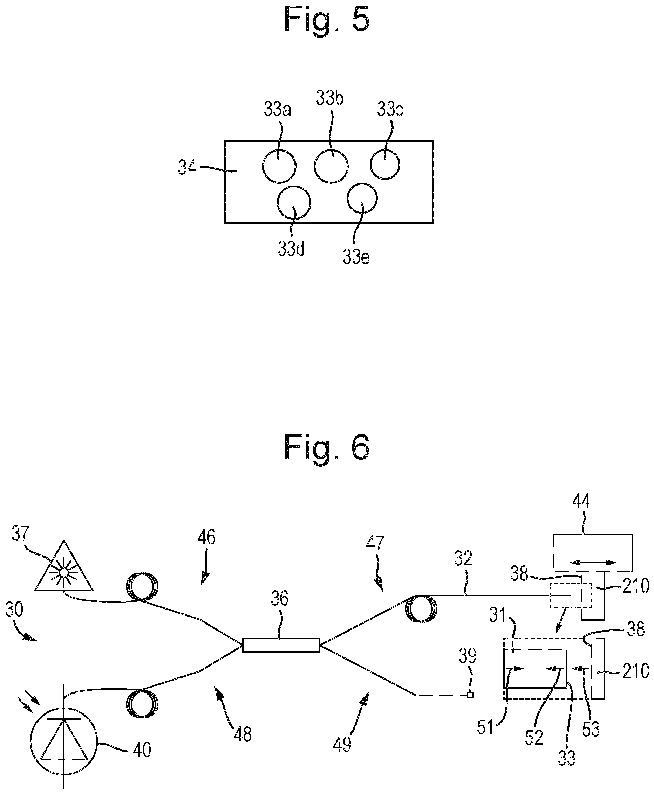

In an embodiment each optical fiber 31 is an independent interferometer. In an embodiment each optical fiber 31 is configured to transmit interrogation lights 51 (see Figure 6) towards the distal end 3 3of the optical fiber 31. By providing the distal end 33 is distance from the surface 38 to be measured, the interrogation 51 which is a fiber-air face at the distal end 33. In an embodiment the optical cavity comprises air. Alternatively, the optical cavity may comprise a different gas. At the fiber-air interface, some of the interrogation radiation 51 is reflected. The reflected radiation 52 that is reflected at the fiber-air interface is transmitted along the optical fiber 31 in the opposite direction from the interrogation radiation 51.

At the fiber-air interface, some of the interrogation radiation 51 is transmitted into the optical cavity (see the transmitted radiation 35 in Figure 4) so as to reach the surface 38 of the donor substrate 210. The interrogation radiation 51 that is transmitted through the optical cavity may be reflected at the surface 38. The reflected radiation 53 that is reflected at the surface 38 may re-enter the optical fiber 31 so as to be transmitted along the optical fiber 31 in the opposite direction from the interrogation radiation 51.

It is not essential for the measurement system 30 to comprise a plurality of optical fibers 31. In an alternative embodiment the measurement system 30 comprises one optical fiber 31. Interrogation radiation 51 of different wavelengths can be provided to the optical fiber 31 at different times. Each optical fiber 31 receives interrogation radiation 51 of a single wavelength at any one time.

In an embodiment the wavelength of interrogation radiation 51 provided to one or more of the optical fibers 31 is switched between multiple wavelengths. In an embodiment the measurement system 30 is configured for one or more of time multiplexing, frequency multiplexing and wavelength multiplexing.

In an embodiment a mix of different wavelengths is provided to each one of the optical fibers 31. Alternatively, a different wavelength may be provided for each one of the optical fibers 31. In an alternative embodiment, the plurality of optical fibers 31 comprises at least a first group receiving a first wavelength of interrogation radiation 51, and a second group receiving a second wavelength of interrogation radiation 51.

In an embodiment the optical fibers 31 are single mode fibers. The optical fibers 31 may have a relatively long coherence length and/or are configured such that any phase shift is detectable.

As shown in Figure 4, in an embodiment the measurement system 30 comprises a detector 40. The detector 40 is configured to detect radiation reflected from the surface 38 and radiation reflected from the distal ends 33. By detecting the reflected radiation 52 that is reflected from the distal ends 33 as well as the reflected radiation 53 that is reflected from the surface 38, an interference signal may be formed. The reflected radiation 52 that is reflected from the distal ends 33 and the reflected radiation 53 that is reflected from the surface 38 interfere with each other. The intensity of the interference signal depends on the length of the optical cavity, i.e. depends on the height of the surface 38. In an embodiment the height or profile of the surface 38 may be determined dependent on the interference signal. The height changes across the surface 38 is the interference signal to change.

As shown in Figure 4, in an embodiment the detector 40 comprises a photodetector 41 such as a photoreceiver. The photodetector 41 is configured to detect photons from the reflected radiation 52, 53 (see Figure 6). In an embodiment a separate photodetector 41 is provided for respective optical fibers 31 or respective groups of optical fibers 31. For example different photodetectors 41 may be provided for detecting the result of different wavelengths of interrogation radiation 51 being used. Alternatively different portions of the same photodetector 41 may be provided for different optical fibers 31 and/or different wavelengths of interrogation radiation 51.

An embodiment of the invention is expected to achieve an increased capture range. The optical fiber-based measurement system 30 may be configured to direct the interrogation radiation 51 substantially perpendicularly (or close to perpendicularly) to the surface 38. It is not necessary to apply the radiation from the side. Different distances to the surface 38 may be measured by detecting radiation incident on substantially the same area of the detector 40. A change in the distance to the surface 38 may not result in a shift in the location of radiation detected on the detector 40. This is in contrast to known level sensors that use optical triangulation.

In an embodiment multiple wavelengths of interrogation radiation 51 are multiplexed to a single optical fiber 31. In an embodiment the detector 40 is configured to demultiplex to separate the measurements from the different wavelengths.

As shown in Figure 4, in an embodiment the measurement system 30 comprises a radiation source 37. In an embodiment the radiation source 37 is configured to provide interrogation radiation 51 of different wavelengths to the plurality of optical fibers 31a, 31b, 31c. For example, the radiation source 37 may be configured to provide interrogation radiation 51 of a first wavelength to a first optical fiber 31a. The radiation source 37 may be configured to priced interrogation radiation 51 on a second wavelength to the second optical fiber 31b. The radiation source 37 may be configured to provide interrogation radiation 51 of a third wavelength to the third optical fiber 31c. In an embodiment the first wavelength is different from the second wavelength. In an embodiment the first wavelength is different from the third wavelength. In an embodiment the second wavelength is different from the third wavelength.

In an embodiment the radiation source 37 comprises a plurality of radiation sources configured to output radiation of different wavelengths. In an embodiment the radiation source 37 is configured to output interrogation radiation 51, wherein each wavelength of interrogation radiation 51 has a narrow bandwidth. For example the radiation source 37 may comprise one or more single frequency lasers.

An embodiment of the invention is expected to improve accuracy of measurements of the distance to the surface 38. By combining the height signal from a plurality of different wavelengths, the error in the height information measured may be reduced. The signal from each individual optical fiber 31 may be affected by the layers at the surface 38 leading to error. By combining the signals from a plurality of optical fibers 31, the error may be reduced. The error associated with different wavelengths of interrogation radiation 51 may have oppositely signs. By combining the signals, the error may be averaged out and thereby reduced.

By reducing the error in the height measurement, the focus of the alignment system may be controlled more accurately. An embodiment of the invention is expected to improve alignment for bonding. An embodiment of the invention is expected to increase the extent by which the bonding process can be controlled.

In an embodiment the number of different wavelengths substantially corresponds to the number of different optical fibers 31 having distal ends 33 distanced from the surface 38 to be measured. In an embodiment, the number of wavelengths can be increased or lowered to match the use case. The number of wavelengths may be selected depending on how the measurement system 30 is to be used. The radiation source 37 generates a plurality of distinct wavelengths of radiation, rather than supplying a broadband source. The radiation supplied by the radiation source 37 is substantially coherent, and thereby suitable for interferometry.

In an embodiment the detector 40 is configured to detect radiation from the plurality of optical fibers 31 substantially independently of each other. That is, the optical fibers 31 function as substantially independent interferometers.

In an embodiment the detector 40 is configured to output a signal indicative of the distance to the surface 38 dependent on the detected radiation. The detected radiation may comprise the reflected radiation 52 reflected at the fiber-air interface and the reflected radiation reflected at the surface 38 to be measured. In an embodiment the signal that is output by the detector 14 is an interference signal. Alternatively, the detector 40 may be configured to process the interference signal and to output the process signal.

As shown in Figure 4, in an embodiment the detector 40 comprises a detector module 42. The detector module 42 may be implemented at least partly in software. For example, the detector module 42 may be software run on a processor. In an embodiment the detector 40 comprises the processor configured to run the detector module 42.

In an embodiment the detector module 42 is configured to determine the interference signal based on the radiation detected by the photoreactor 41 of the detector 40. The photodetector 41 is configured to output the detected photon signal to the detector module 42. In an embodiment the detector module 42 is configured to process the detected signal. For example, the detector module 42 may be configured to combine the height signal from a plurality of, for example all of, the different wavelengths corresponding to the different optical fibers 31a, 31b, 31c.

In an embodiment the detector 40 is configured to output the signal dependent on a combination of the detected radiation from a plurality of the plurality of optical fibers 31a, 31b, 31a. For example, the signals from all of the wavelengths of interrogation radiation 51 may be combined. Alternatively, a selection of the wavelengths of interrogation radiation 51 may be made for combining the measurements. For example one of more wavelengths may be excluded when it is determined that the surface to be measured is not sensitive to the wavelength.

In an embodiment the radiation reflected from the surface 38 and the radiation reflected from the distal end 33 interfere such that a detected intensity depends periodically on a length of the optical cavity. In an embodiment the detector 40 is configured to detect two quadrature signals of first harmonics. The detector 40 may be configured to detect a varying phase of the detected intensity within the periodical dependence of the detected intensity on the length of the optical cavity. For example, it may be determined whether the signal is at a peak, a trough or somewhere between. In an embodiment the detector 40 is configured to distinguish between different lengths of the optical cavity that correspond to the same detected intensity. By monitoring the phase within the period, it can be determined when the phase has moved beyond a peak, for example. By counting the number of times that a peak has been exceeded, it may be possible to distinguish between different lengths of the optical cavity that otherwise correspond to the same detected intensity.

In an embodiment the measurement system 30 is configured to modulate the wavelength of interrogation radiation 51 for at least one of the optical fibers 31. The modulation may be over a smaller wavelength range than a difference in wavelength supplied to different optical fibers 31. By modulating the wavelength, small changes in intensity may be detected. By determining the magnitude and sign of the variations in intensity as a function of the modulation of the wavelength it may be possible to determine the phase with the periodical intensity curve.

An embodiment of the invention is expected to increase the linear regime. Instead of only being able to determine height changes within one period, it may be possible to distinguish between different cycles by counting shifts between cycles (i.e. counting the phase wrap).

As an alternative to modulating the wavelength of radiation, in an embodiment the measurement system 30 is configured to modulate the length of the optical cavity. For example, in an embodiment the actuator 44 (shown in Figure 6) is configured to modulate a location of the surface 38 to be measured towards and away from the optical fibers 31. For example, the actuator 44 may correspond to a stage or a table configured to position the substrate that comprises the surface 38 to be measured. Alternatively, the actuator 44 may be provided as an additional actuator, for example a piezoelectric actuator configured to actuate the surface 38, for example towards and away from the optical fibers 31. As a further alternative the measurement system 30 may be configured to actuate the distal ends 33 towards and away from the surface 38 so as to modulate the length of the optical cavity.

In an embodiment the radiation source 37 is configured to vary the wavelength of interrogation wavelength 51 provided to at least one optical fiber 31 so as to perform a wavelength sweep. In an embodiment the detector 40 is configured to determine a distance to the surface 38 based on measurements associated with the wavelength sweep.

As shown in Figure 4, in an embodiment each optical fiber 31 is connected to an optical device 36. For example, the first optical fiber 31a is connected to a first optical device 36a. A second optical fiber 31b is connected to a second optical device 36b. The third optical fiber 31c is connected to a third optical device 36c. The optical device 36 may be a fiber coupler or a fiber circulator, for example. The optical device 36 is configured to connect a plurality of branches of optical transmission lines.

As shown in Figure 4, in an embodiment the measurement system 30 comprises optical transmission lines 32. An optical transmission line 32 may be configured to connect to the optical fiber 31 to the optical device 36. In an embodiment the optical transmission line 32 between the optical fiber 31 and the optical device 36 is a continuation of the optical fiber 31. The optical fiber 31 may be formed integrally with the optical transmission line 32.

As shown in Figure 4, in an embodiment an optical transmission line is configured to connect the light source 37 to the optical device 36. An optical transmission line is configured to connect the optical device 36 to the detector 40.

During use of the measurement system 30, interrogation light 51 may be provided by the light source 37. The interrogation radiation 51 is transmitted along an optical transmission line to the optical device 36. The optical device 36 transmits the interrogation radiation along a branch towards the optical fiber 31. The reflected radiation 52, 253 is transmitted by an optical transmission line 32 to the optical device 36. The optical device 36 is configured to transmit the reflected radiation 52, 53 to the detector 40.

Figure 5 schematically depicts an end-on view the optical fibers 31 shown in Figure 4. As shown in Figure 5, in an embodiment the measurement system 30 comprises five optical fibers 31. Each optical fiber 31 has a distal end 33a, 33b, 33c, 33d, 33e. The five distal ends 33 are distance from the surface 38 to be measured.

As shown in Figure 5, in an embodiment the plurality of optical fibers 31 are arranged such that the distal ends 33a, 33b, 33c, 33d, 33e are close to each other. For example they may be adjacent to each other. The distal ends 33 may be arranged close to each other. For example, the optical fibers 31 may be arranged in a bundle, at least near the distal ends 33. In an embodiment the plurality of optical fibers 31 are arranged such that the distal ends 33 have a centre-to-centre distance of at most 10 times, optionally at most five times and optionally at most two times the diameter of the optical fibers 31.

As shown in Figure 5, in an embodiment the plurality of optical fibers 31 are arranged such that the distal ends 33 form a shape. For example, in the arrangement shown in Figure5 the optical fibers 31 are arranged such that the distal ends 33 form a hexagonal grid. This may reduce the space required for the optical fibers 31 of the measurement system 30. An embodiment of the invention is expected to provide a more compact measurement system 30.

As shown in Figure 5, in an embodiment the plurality of optical fibers 31 are arranged such that any gaps between adjacent distal ends 33 are smaller than a diameter of the distal ends 33. As shown in Figure 5, in an embodiment there are gaps between adjacent distal ends 33. That is, the distal ends are distanced from each other in a plane perpendicular to a transmission direction of the optical fibers 31. In the arrangement shown in Figure 5, the distal ends 33 are substantially circular. Alternatively, the distal ends 33 may be polygonal, for example hexagonal or octagonal. The distal ends 33 have a dimension (e.g. diameter) in a direction perpendicular to the transmission direction of the optical fiber 31. In the arrangement shown in Figure 5, the gaps between the distal ends 33 are generally smaller than the diameters of the distal ends 33.

However, it is not essential for the gaps between distal ends 33 to be smaller than the dimensions of the distal ends 33. In an alternative embodiment, the distal ends 33 are spaced further apart from each other.

As shown in Figure 5, in an embodiment the measurement system 30 comprises a housing 34. The housing 34 may be configured to house the ends of the optical fibers 31. In an embodiment the housing 34 is configured to fix the relative positions between the distal ends 33 of the optical fibers 31. An embodiment of the invention is expected to increase stability of the measurement system 30.

Figure 6 schematically depicts a measurement system 30, for example of the type shown in Figure 4. Figure 6 schematically depicts any one labelling of interrogation radiation 51 corresponding to one optical fiber 31. In an embodiment, the measurement system 30 is configured to use a plurality of wavelengths of interrogation radiation 31 transited along respective optical fibers 31.

In the arrangement shown in Figure 6, the optical device 36 comprises a fiber coupler. The coupler is configured to connect four different branches of optical transmission lines. A first branch 46 corresponds to interrogation radiation 51 output by the radiation source 37 to the optical device 36. A second branch 47 corresponds to the interrogation light 51 transmitted from the optical device 36 to the optical fiber 31 and towards the surface 38 to be measured. The second branch 47 also corresponds to the reflected radiation 52, 53 transmitted along the optical transmission line 32 back to the optical device 36.

A third branch 48 corresponds to reflected radiation 52, 53 transmitted by the device 36 to the detector 40.

Figure 6 also schematically shows a close up view of the distal end 33 of the optical fiber 31 forming an optical cavity between the distal end 33 and the surface 38 of the donor substrate 210 to be measured. The close-up view shows the reflected radiation 54 reflected at the fiber-interface as well as the reflected radiation 53 reflected at the surface 38 to be measured.

As shown in Figure 6, in an embodiment the optical deice 36 is further configured to connect to a fourth branch 49. The fourth branch 49 is blocked by a blocker 39. For example, the blocker 39 may be an absorber configured to absorb the interrogation radiation that is transmitted along the fourth branch 49.

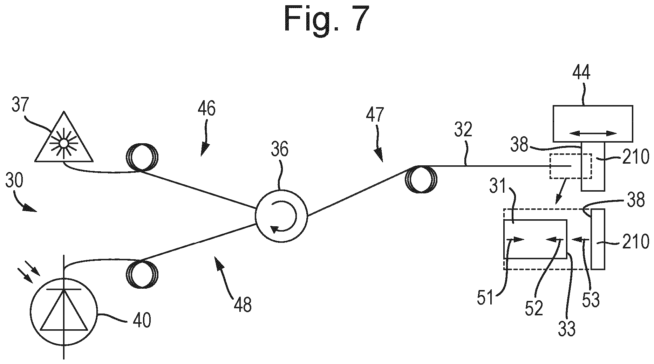

It is not essential for the optical device 36 to be a fiber coupler as shown in Figure 6. In an alternative embodiment the optical device 36 comprises a fiber circulator, as shown in Figure 7. The fourth branch 49 may be omitted, as shown in Figure 7. The fiber circulator may be configured to transmit interrogation radiation 51 from the first branch 36 to the second branch 47. The fiber circulator may be configured to transmit the reflected radiation 52, 53 from the second branch 47 to the third branch 48. An embodiment of the invention is expected to reduce wasted interrogation radiation 51.

In an embodiment the optical device 36 comprises a prism configured to separate the interrogation radiation 51 into a plurality of sub-beams.

Figure 8 schematically depicts an alternative measurement system 30. In the arrangement shown in Figure 8, the fourth branch 49 is replaced with a reference branch 45. As shown in Figure 8, in an embodiment the reference branch 45 comprises a reference optical fiber 31r. The reference optical fiber 31r may be located distanced from a reference reflector 46. In an embodiment, the reference reflector 46 (e.g. mirror) has a known distance from the reference optical fiber 31r. For example, the reference reflector 46 may be substantially planar. In an embodiment, radiation that is reflected at the fiber-air interface and at the reference reflector 46 of the reference branch 45 are detected by the detector 40.

In an embodiment the detector 40 is configured to output a signal dependent on the radiation reflected from the reference branch 45. By providing the reference branch 45, an embodiment of the invention is expected to reduce noise in the signal output by the detector 40.

However, it is not essential to provide the reference branch 45. In an alternative arrangement, the reference branch 45 may be omitted, for example as shown in Figure 6.

In an embodiment the measurement system 30 comprises a collimator. The collimator is configured to collimate radiation output by the plurality of optical fibers 31. In an embodiment the bundle of optical fibers 31 is associated with a collimating lens. In an embodiment a plurality of collimators are provided for respective optical fibers 31. In an embodiment a focusing element may be provided for focusing the radiation 35 output by the optical fibers 31. The radiation 35 may be focused onto the surface 38.

Figure 9 schematically depicts a possible arrangement of the measurement system 30 relative to an alignment system such as the location measurement system 240. In an embodiment the optical fibers 31 are arranged such that their distal ends 33 are located around the alignment system, for example around an optical axis of the alignment system at a location where radiation is emitted for measuring alignment. In an embodiment the alignment sensor comprises an objective. In an embodiment the optical fibers 31 are arranged such that their distal ends 33 are located around the objective. Alternatively, the alignment sensor may have a fiber output with the end of the fiber shaped such that the radiation is focussed. In an embodiment the optical fibers 31 are arranged such that their distal ends 33 are located around the end of the fiber of the alignment sensor. As shown in Figure 9, in an embodiment the distal ends 33 are arranged to form an annulus around the optics of the alignment system. In an embodiment the bundle configuration is designed as a ring. By arranging the optical fibers 31 around the alignment sensor objective, it may be easier to fit the measurement system 30 for a given location of the alignment sensor. An embodiment of the invention is expected to reduce the complexity of the combination of the measurement system 30 with the alignment system. An embodiment of the invention is expected to allow for easier integration of the measurement system 30 with the alignment sensor.

As shown schematically in Figure 4, the surface 38 of the donor substrate 210 to be measured may comprise a plurality of layers. For example, the donor substrate 210 may comprise one or more of a resist areal, and anti-reflective coating, a hardmask and a product layer formed on a base substrate (e.g. a silicone substrate). The anti-reflective coating may be a buried anti-reflective coating, for example. In an embodiment, the resist material forms the outer most surface of the donor substrate 210. It may be desirable to determine the actual high of the resist material that forms the outermost layer of the donor substrate 210. However, it is possible that an illumination beam incident on the surface 38 penetrates through one or more of the layers of the donor substrate 210 and is reflected at an interface between different layers. This can cause an error in the measured distance to the surface 38. This may be referred to as a height process dependency error.

By providing the radiation source 37 with a priority of different wavelengths along the different optical fibers 31, the height dependency error may be reduced. An embodiment of the invention is expected to increase the accuracy of measurement of the distance.

The measurement system 30 is described primarily in the context of a bonding tool. However, it is not essential for the measurement system 30 to be used only in a bonding tool. The measurement system 30 may be used as a level sensor or a topograhpy measurement system, for example, in the context of the lithography.

Embodiments of the measurement system have been described primarily in the context of a bonding tool. However, it is not essential for the measurement system to be used only in a bonding tool. In an alternative embodiment the measurement system is used in a lithographic apparatus.

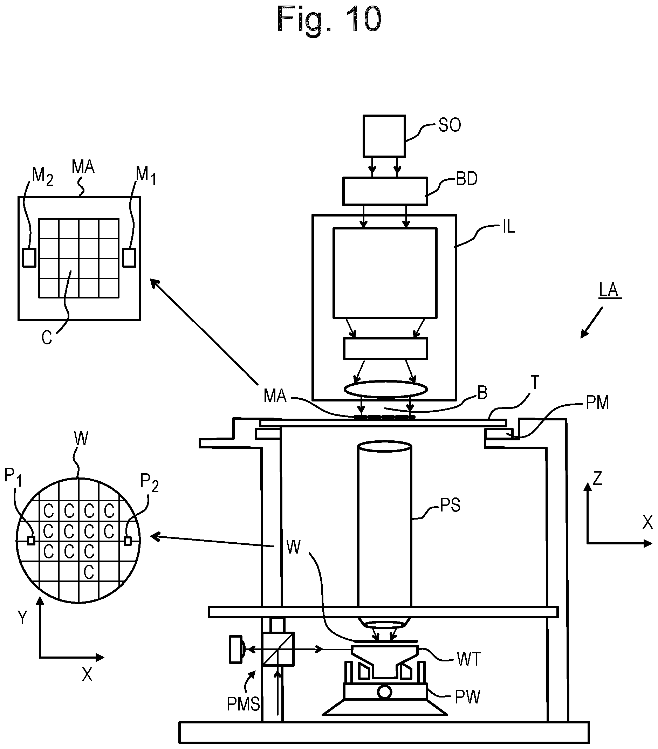

Figure 10 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 10) may be used to accurately position the patterning device MA with respect to the path of the radiation beam B. Patterning device MA and substrate W may be aligned using mask alignment marks M1, M2 and substrate alignment marks P₁, P₂. Although the substrate alignment marks P₁, P₂ as illustrated occupy dedicated target portions, they may be located in spaces between target portions. Substrate alignment marks P₁, P₂ are known as scribe-lane alignment marks when these are located between the target portions C.

A topography measurement system, level sensor or height sensor, and which may be integrated in the lithographic apparatus, is arranged to measure a topography of a top surface of a substrate (or wafer). A map of the topography of the substrate, also referred to as height map, may be generated from these measurements indicating a height of the substrate as a function of the position on the substrate. This height map may subsequently be used to correct the position of the substrate during transfer of the pattern on the substrate, in order to provide an aerial image of the patterning device in a properly focus position on the substrate. It will be understood that "height" in this context refers to a dimension broadly out of the plane to the substrate. Typically, the level or height sensor performs measurements at a fixed location (relative to its own optical system) and a relative movement between the substrate and the optical system of the level or height sensor results in height measurements at locations across the substrate.

Any embodiment of the topography measurement system may be integrated in a lithographic apparatus, such as the lithographic apparatus shown in Figure 10. All embodiments of the measurement system 30 discussed in the context of a bonding tool also apply to a topography measurement system for a lithographic apparatus, such as the lithographic apparatus shown in Figure 10.

The methods of the present invention may be performed by computer systems comprising one or more computers. A computer used to implement the invention may comprise one or more processors, including general purpose CPUs, graphical processing units (GPUs), tensor processing units (TPU) or other specialised processors. A computer used to implement the invention may be physical or virtual. A computer used to implement the invention may be a server, a client or a workstation. Multiple computers used to implement the invention may be distributed and interconnected via a network such as a local area network (LAN) or wide area network (WAN). Individual steps of the method may be carried out by a computer system but not necessarily the same computer system. Results of a method of the invention may be displayed to a user or stored in any suitable storage medium. The present invention may be embodied in a non-transitory computer-readable storage medium that stores instructions to carry out a method of the invention. Any suitable programming language may be used to implement the invention. The present invention may be embodied in a computer system comprising one or more processors and memory or storage storing instructions to carry out a method of the invention.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

Aspects of the invention are described in the following numbered clauses.
1. A bonding tool configured to bond a first substrate to a second substrate, the bonding tool comprising:
   a measurement system configured to measure a distance to a surface of at least one of the first substrate, the second substrate,
   a substrate holder configured to hold the first substrate and a substrate holder configured to hold the second substrate,
   the measurement system comprising:
      at least one optical fiber having a distal end distanced from the surface so as to form an optical cavity of a Fabry-Pérot interferometer between the distal end and the surface; and
      a radiation source configured to provide interrogation radiation of different wavelengths to the at least one optical fiber.
2. The bonding tool of clause 1, the measurement system comprising:
   a plurality of optical fibers having respective distal ends distanced from the surface so as to form respective optical cavities of respective Fabry-Pérot interferometers between the respective distal ends and the surface, wherein the radiation source is configured to provide the interrogation radiation of different wavelengths to the plurality of optical fibers.
3. The bonding tool of clause 2, wherein the radiation source is configured to provide the interrogation radiation of different wavelengths such that each of the plurality of optical fibers is provided with interrogation radiation of one wavelength.
4. The bonding tool of clause 2, wherein the plurality of optical fibers comprises a plurality of groups of optical fibers, wherein the radiation source is configured to provide the interrogation radiation of different wavelengths such that each group of optical fibers is provided with interrogation radiation of one wavelength.
5. The bonding tool of clause 1 or 2, wherein the radiation source is configured to provide the interrogation radiation of different wavelengths to the at least one optical fiber such that different wavelengths of radiation are provided at different times such that the or each optical fiber is provided with interrogation radiation of one wavelength at any one time.
6. The bonding tool of any preceding clause, the measurement system comprising:
   a detector configured to detect radiation reflected from the surface and from the distal ends.
7. The bonding tool of clause 6, wherein the detector is configured to detect radiation from the plurality of optical fibers independently of each other.
8. The bonding tool of clause 6 or 7, wherein the detector is configured to output a signal indicative of the distance to the surface dependent on the detected radiation.
9. The bonding tool of clause 8, wherein the detector is configured to output the signal dependent on a combination of the detected radiation from a plurality of the optical fibers.
10. The bonding tool of any of clauses 6-9, wherein the radiation reflected from the surface and the radiation reflected from the distal end interfere such that a detected intensity depends periodically on a length of the optical cavity.
11. The bonding tool of clause 10, wherein the detector is configured to detect a varying phase of the detected intensity within the periodical dependence of the detected intensity on the length of the optical cavity, such that the detector is configured to distinguish between different lengths of the optical cavity that correspond to the same detected intensity.
12. The bonding tool of any preceding clause, wherein the plurality of optical fibers are arranged such that the distal ends are close to each other.
13. The bonding tool of clause 12, wherein the plurality of optical fibers are arranged such that the distal ends form a shape.
14. The bonding tool of clause 13, wherein the shape is an annulus.
15. The bonding tool of any of clauses 12-14, wherein the plurality of optical fibers are arranged such that any gaps between adjacent distal ends are smaller than a diameter of the distal ends.
16. The bonding tool of any preceding clause, wherein the plurality of optical fibers are connected to respective optical devices configured such that radiation from the radiation source is directed by the optical fiber towards the surface and radiation reflected from the surface and from the distal end is directed to a detector.
17. The bonding tool of clause 16, wherein the optical devices are configured such that radiation from the radiation source is additionally directed along a reference branch comprising a reference mirror to provide reference data.
18. The bonding tool of clause 16 or 17, wherein the optical device is an fiber optic coupler or an optical circulator.
19. The bonding tool of any preceding clause, comprising:
   a collimator configured to collimate radiation output towards the surface from the at least one of optical fibers.
20. The bonding tool of any preceding clause, wherein a die is the first substrate, wherein the measurement system is configured to measure the distance to a surface of the die.
21. The bonding tool of any preceding clause, comprising:
   a stage configured to hold the die.
22. The bonding tool of clause 20 or 21, comprising:
   an alignment sensor configured to measure alignment of the die, wherein focus of the alignment sensor on the die is controllable dependent on the distance to the surface of the die measured by the measurement system.
23. The bonding tool of clause 22, wherein the plurality of optical fibers are arranged such that the distal ends are located around an optical axis of the alignment sensor at a location where radiation is emitted towards the die.
24. The bonding tool of any of clauses 20-23, wherein the measurement system is configured to measure the distance to a surface of an acceptor substrate as the second substrate.
25. The bonding tool of any of clauses 20-24, comprising:
   a controller configured to control bonding between the first substrate and the second substrate based on the distance measured by the measurement system.
26. The bonding tool of any preceding clause, wherein the radiation source is configured to modulate the wavelength of the interrogation radiation for at least one of the optical fibers.
27. A topography measurement system configured to measure a topography of a surface of a substrate, the topography measurement system comprising:
   a plurality of optical fibers having respective distal ends distanced from the surface so as to form respective optical cavities of respective Fabry-Pérot interferometers between the respective distal ends and the surface; and
   a radiation source configured to provide interrogation radiation of different wavelengths to the plurality of optical fibers such that a first group of the optical fibers receives interrogation radiation of a first wavelength and a second group of the optical fibers receives interrogation radiation of a second wavelength.
28. A lithographic apparatus configured to expose a substrate with patterned radiation, the lithographic apparatus comprising:
   the topography measurement system of clause 27.
29. A method for measuring a distance to a surface of at least one of a first substrate, a second substrate, a first substrate holder configured to hold the first substrate and a second substrate holder configured to hold the second substrate, wherein the first substrate and the second substrate are to be bonded in a bonding tool, the method comprising:
   arranging at least one optical fiber to have a distal end distanced from the surface so as to form an optical cavity of a Fabry-Pérot interferometer between the distal end and the surface; and
   providing interrogation radiation of different wavelengths to the at least one optical fiber.

## Claims

1. A bonding tool configured to bond a first substrate to a second substrate, the bonding tool comprising:
a measurement system configured to measure a distance to a surface of at least one of the first substrate, the second substrate, a substrate holder configured to hold the first substrate and a substrate holder configured to hold the second substrate, the measurement system comprising:
at least one optical fiber having a distal end distanced from the surface so as to form an optical cavity of a Fabry-Pérot interferometer between the distal end and the surface; and
a radiation source configured to provide interrogation radiation of different wavelengths to the at least one optical fiber.

2. The bonding tool of claim 1, the measurement system comprising:
a plurality of optical fibers having respective distal ends distanced from the surface so as to form respective optical cavities of respective Fabry-Pérot interferometers between the respective distal ends and the surface, wherein the radiation source is configured to provide the interrogation radiation of different wavelengths to the plurality of optical fibers.

3. The bonding tool of claim 2, wherein the radiation source is configured to provide the interrogation radiation of different wavelengths such that each of the plurality of optical fibers is provided with interrogation radiation of one wavelength.

4. The bonding tool of claim 2, wherein the plurality of optical fibers comprises a plurality of groups of optical fibers, wherein the radiation source is configured to provide the interrogation radiation of different wavelengths such that each group of optical fibers is provided with interrogation radiation of one wavelength.

5. The bonding tool of claim 1 or 2, wherein the radiation source is configured to provide the interrogation radiation of different wavelengths to the at least one optical fiber such that different wavelengths of radiation are provided at different times such that the or each optical fiber is provided with interrogation radiation of one wavelength at any one time.

6. The bonding tool of any preceding claim, the measurement system comprising at least one of:
a detector configured to detect radiation reflected from the surface and from the distal ends, and
the detector is configured to detect radiation from the plurality of optical fibers independently of each other.

7. The bonding tool of claim 6, wherein the detector is configured to output a signal indicative of the distance to the surface dependent on the detected radiation.

8. The bonding tool of claim 6 or claim 7, wherein the radiation reflected from the surface and the radiation reflected from the distal end interfere such that a detected intensity depends periodically on a length of the optical cavity.

9. The bonding tool of claim 8, wherein the detector is configured to detect a varying phase of the detected intensity within the periodical dependence of the detected intensity on the length of the optical cavity, such that the detector is configured to distinguish between different lengths of the optical cavity that correspond to the same detected intensity.

10. The bonding tool of any preceding claim, wherein the plurality of optical fibers are arranged such that the distal ends are close to each other.

11. The bonding tool of any preceding claim, wherein the plurality of optical fibers are connected to respective optical devices configured such that radiation from the radiation source is directed by the optical fiber towards the surface and radiation reflected from the surface and from the distal end is directed to a detector.

12. The bonding tool of any preceding claim, wherein a die is the first substrate, wherein the measurement system is configured to measure the distance to a surface of the die.

13. The bonding tool of claim 12, comprising:
an alignment sensor configured to measure alignment of the die, wherein focus of the alignment sensor on the die is controllable dependent on the distance to the surface of the die measured by the measurement system.

14. The bonding tool of claim 13, wherein the plurality of optical fibers are arranged such that the distal ends are located around an optical axis of the alignment sensor at a location where radiation is emitted towards the die.

15. A method for measuring a distance to a surface of at least one of a first substrate, a second substrate, a first substrate holder configured to hold the first substrate and a second substrate holder configured to hold the second substrate, wherein the first substrate and the second substrate are to be bonded in a bonding tool, the method comprising:
arranging at least one optical fiber to have a distal end distanced from the surface so as to form an optical cavity of a Fabry-Pérot interferometer between the distal end and the surface; and
providing interrogation radiation of different wavelengths to the at least one optical fiber.
